(19) **Europäisches Patentamt**
**European Patent Office**
**Office européen des brevets**

(11) **EP 2 265 690 B1**

(12) **FASCICULE DE BREVET EUROPEEN**

(45) Date de publication et mention
de la délivrance du brevet:
**03.07.2019 Bulletin 2019/27**

(51) Int Cl.:
***C09K 11/77*** *(2006.01)* ***C01F 7/16*** *(2006.01)*

(21) Numéro de dépôt: **09723596.4**

(86) Numéro de dépôt international:
**PCT/EP2009/052795**

(22) Date de dépôt: **10.03.2009**

(87) Numéro de publication internationale:
**WO 2009/115435 (24.09.2009 Gazette 2009/39)**

(54) **ALUMINATE DE BARYUM ET DE MAGNESIUM SUBMICRONIQUE, PROCEDE DE PREPARATION ET UTILISATION COMME LUMINOPHORE**

SUBMIKRONISCHES BARIUM- UND MAGNESIUM-ALUMINAT, VERFAHREN ZU SEINER HERSTELLUNG UND SEINER VERWENDUNG ALS PHOSPHOR

SUBMICRONIC BARIUM AND MAGNESIUM ALUMINATE, METHOD FOR MAKING SAME AND USE THEREOF AS A PHOSPHOR

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **18.03.2008 FR 0801468**

(43) Date de publication de la demande:
**29.12.2010 Bulletin 2010/52**

(73) Titulaire: **Rhodia Opérations**
**93306 Aubervilliers (FR)**

(72) Inventeurs:
  • **BUISSETTE, Valérie**
    **F-75015 Paris (FR)**
  • **LE-MERCIER, Thierry**
    **F-93110 Rosny-sous-Bois (FR)**
  • **THIERS, Laurent**
    **F-91600 Savigny-sur-Orge (FR)**
  • **MONTARDI, Yvan**
    **F-95240 Cormeilles-en-Parisis (FR)**
  • **LE-ROUX, Olivier**
    **F-93110 Rosny-sous-Bois (FR)**

(74) Mandataire: **Senninger, Thierry et al**
**Rhodia Operations**
**Département Brevets**
**Bureau 0.121**
**40, rue de la Haie Coq**
**93306 Aubervilliers Cedex (FR)**

(56) Documents cités:
**JP-A- 2007 246 873    US-A1- 2003 203 205**

• **A. WATANABE ET. AL.: "Synthesis of Blue Phosphor, BaMgAl10O17:Eu2+, from Flash Creation Method derived Nanopowder" ITE LETTERS ON BATTERIES, NEW TECHNOLOGIES & MEDICINE, vol. 8, no. 1, 2007, pages 38-41, XP009102810**
• **C. PANATARANI ET. AL.: "Polymer-supported solution synthesis of blue luminescent BaMgAl10O17:Eu2+ particles" MATERIALS SCIENCE AND ENGENEERING, vol. 122, 2005, pages 188-195, XP002487291 Elsevier**
• **K. OKUYAMA ET. AL.: "Preparation of nanoparticles via spray route" CHEMICAL ENGENEERING SCIENCE, vol. 58, 2003, pages 537-547, XP002487292 Pergamon**

**Description**

La présente invention concerne un aluminate de baryum et de magnésium submicronique, son procédé de préparation et l'utilisation de cet aluminate comme luminophore.

Les domaines de la luminescence et de l'électronique connaissent actuellement des développements importants. On peut citer comme exemple de ces développements, la mise au point des systèmes à plasma (écrans et lampes) pour les nouvelles techniques de visualisation, d'éclairage ou de marquage. Ces nouvelles applications nécessitent des matériaux luminophores présentant des propriétés encore améliorées. Ainsi, outre leur propriété de luminescence, on demande à ces matériaux des caractéristiques spécifiques de morphologie ou de granulométrie afin de faciliter notamment leur mise en oeuvre dans les applications recherchées.

Plus précisément, il est demandé d'avoir des luminophores se présentant sous la forme de particules le plus possible individualisées et de taille très fine, submicronique, notamment inférieure à 500 nm. Des particules d'aluminate de baryum et de magnésium avec des tailles inférieures à 500 nm sont connues de JP 2007-246873, US 2003/0203205, Watanabe A. et al., ITE Letters on Batteries, New Technologies & Medicine, Vol. 8, No. 1 (2007, pp. 38-41 et Panatarani, C. et al., Materials Science and Engineering B, Vol. 122 (2005), pp. 188-195.

On connaît des procédés de préparation de luminophores par chamottage. Toutefois, ces procédés nécessitent pour obtenir les phases cristallographiques recherchées une calcination à une température élevée ce qui a pour conséquence généralement de conduire à des produits difficiles à broyer de sorte qu'il est impossible d'atteindre une telle taille.

Par ailleurs et toujours dans le cadre du développement dans les domaines de la luminescence et de l'électronique, on cherche à obtenir des matériaux, sous forme de couches minces, transparentes et luminescentes.

L'objet principal de l'invention est de procurer des produits ayant de telles caractéristiques granulométriques.

Un second objet de l'invention est d'obtenir un matériau luminescent du type ci-dessus.

Dans ce but, l'aluminate de baryum et de magnésium de l'invention est caractérisé en ce qu'il se présente sous forme d'une suspension dans une phase liquide de particules substantiellement monocristallines de taille moyenne comprise entre 100 et 150 nm.

D'autres caractéristiques, détails et avantages de l'invention apparaîtront encore plus complètement à la lecture de la description qui va suivre, ainsi que des dessins annexés dans lesquels :

- la figure 1 est un diagramme RX d'un aluminate selon l'invention;
- la figure 2 est un spectre d'émission de ce même aluminate;
- la figure 3 est une photo MET d'une seconde suspension selon l'invention;
- la figure 4 est une photo MET d'une troisième suspension selon l'invention;
- la figure 5 est un spectre d'émission d'un quatrième aluminate selon l'invention;
- la figure 6 est un spectre d'émission d'un cinquième aluminate selon l'invention.

Par terre rare on entend dans la présente description les éléments du groupe constitué par l'yttrium et les éléments de la classification périodique de numéro atomique compris inclusivement entre 57 et 71.

L'aluminate de l'invention est constitué de particules qui ont pour caractéristique essentielle d'être submicroniques et monocristallines.

Plus précisément, ces particules présentent une taille moyenne ($d_{50}$) comprise entre 100 et 150 nm. Pour certaines applications de l'aluminate de l'invention, par exemple pour la fabrication d'un matériau transparent, comme décrit plus loin, on peut utiliser un aluminate dont les particules ont une taille comprise entre 100 nm et 150 nm.

Par ailleurs, ces particules peuvent présenter une dispersion granulométrique resserrée; plus précisément leur indice de dispersion est d'au plus 1, de préférence d'au plus 0,7 et encore plus préférentiellement d'au plus 0,5.

Pour l'ensemble de la description, la taille moyenne et l'indice de dispersion sont les valeurs obtenues en mettant en oeuvre la technique de diffraction laser en utilisant un granulomètre laser (répartition en volume).

On entend par indice de dispersion le rapport :

$$\sigma/m = (d_{84} - d_{16})/2d_{50}$$

dans lequel :

- $d_{84}$ est le diamètre des particules pour lequel 84% des particules ont un diamètre inférieur à $d_{84}$;
- $d_{16}$ est le diamètre des particules pour lequel 16% des particules ont un diamètre inférieur à $d_{16}$;
- $d_{50}$ est le diamètre moyen des particules.

Il est précisé ici que les mesures de taille moyenne sont faites sur des suspensions qui n'ont pas subi de décantation, c'est-à-dire sans phase surnageante et sans culot de décantation, et qui, si nécessaire, ont été traitées par un passage à la sonde à ultra-sons selon les méthodes bien connues mise en oeuvre pour ce type de mesures.

L'autre caractéristique des particules constitutives de l'aluminate de l'invention est leur monocristallinité. En effet, pour l'essentiel, c'est-à-dire pour environ au moins 90% d'entre elles et, de préférence pour la totalité d'entre elles, ces particules sont constituées d'un seul cristal.

Cet aspect monocristallin des particules peut être mis en évidence par la technique d'analyse par microscopie électronique par transmission (MET).

Pour les suspensions dont les particules sont dans une gamme de taille d'au plus 200 nm environ, l'aspect monocristallin des particules peut être mis aussi en évidence en comparant la taille moyenne des particules mesurée par la technique de diffraction laser mentionnée plus haut avec la valeur de la mesure de la taille du cristal ou du domaine cohérent obtenue à partir de l'analyse par diffraction des rayons X (DRX). Il est précisé ici que la valeur mesurée en DRX correspond à la taille du domaine cohérent calculé à partir de la raie de diffraction correspondant au plan cristallographique [102]. Les deux valeurs : taille moyenne diffraction laser et DRX présentent en effet le même ordre de grandeur, c'est à dire qu'elles sont dans un rapport (valeur mesure $d_{50}$/ valeur mesure DRX) inférieur à 2, plus particulièrement d'au plus 1,5.

Comme conséquence de leur caractère monocristallin, les particules de l'aluminate de l'invention se présentent sous forme bien séparée et individualisée. Il n'y a pas ou peu d'agglomérats de particules. Cette bonne individualisation des particules peut être mise en évidence en comparant le $d_{50}$ mesuré par la technique de diffraction laser et celui mesuré à partir d'une image obtenue par microscopie électronique à transmission (MET). Ainsi, pour une valeur donnée du d50 mesurée par la technique de diffraction laser (valeur $d_{50}$ laser), la valeur mesurée par MET (valeur MET) est au moins égale à (valeur $d_{50}$ laser)/2 et le rapport valeur $d_{50}$ laser /valeur MET peut être compris entre 1 et 2.

L'aluminate de l'invention est à base d'aluminium, de baryum et de magnésium sous forme d'oxyde mais il peut contenir des éléments additionnels, appelés « substituants » ou « dopants» car ces éléments sont considérés comme venant en substitution partielle des éléments constitutifs Ba, Mg et Al et ils permettent notamment de modifier les propriétés optiques et de luminescence de l'aluminate.

On va donner ci-dessous des exemples de ces substituants pour chaque élément constitutif sur la base de ce qui est communément admis actuellement dans l'état de la technique. Ceci implique que l'on ne sortirait pas de la présente invention si un substituant décrit pour un élément constitutif donné s'avérait être en fait par la suite en substitution d'un autre élément constitutif que celui présumé dans la présente description.

Ainsi, le baryum peut être partiellement substitué par au moins une terre rare qui peut être notamment le gadolinium, le terbium, l'yttrium, l'ytterbium, l'europium, le néodyme et le dysprosium, ces éléments pouvant être pris seuls ou en combinaison. De même, le magnésium peut être partiellement substitué par au moins un élément choisi parmi le zinc, le manganèse ou le cobalt. Enfin, l'aluminium peut aussi être partiellement substitué par au moins un élément choisi parmi le gallium, le scandium, le bore, le germanium ou le silicium.

Les quantités de ces substituants peuvent varier, d'une manière connue, dans de larges gammes, toutefois elles doivent être telles, pour les valeurs maximales, que soit conservée substantiellement la structure cristallographique de l'aluminate. Par ailleurs, la quantité minimale de substituant est celle en deçà de laquelle le substituant ne produit plus d'effet.

Généralement toutefois, la quantité de substituant du baryum est d'au plus 40%, plus particulièrement d'au plus 20% et encore plus particulièrement d'au plus 10%, cette quantité étant exprimée en % atomique (rapport atomique substituant/(substituant + Ba). Pour le magnésium, cette quantité, exprimée de la même manière, est généralement d'au plus 60%, plus particulièrement d'au plus 40% et encore plus particulièrement d'au plus 10%. Pour l'aluminium, cette quantité, toujours exprimée de la même manière, est généralement d'au plus 15%. La quantité minimale de substituant peut être d'au moins 0,1% par exemple.

A titre d'exemple, l'aluminate de l'invention peut répondre à la formule (I) ci-dessous :

$$a(Ba_{1-d}M^1_dO).b(Mg_{1-e}M^2_eO).c(Al_2O_3) \qquad (I)$$

dans laquelle :

$M^1$ désigne une terre rare qui peut être plus particulièrement le gadolinium, le terbium, l'yttrium, l'ytterbium, l'europium, le néodyme et le dysprosium;
$M^2$ désigne le zinc, le manganèse ou le cobalt;
a, b, c, d et e vérifient les relations :
$0,25 \leq a \leq 2$; $0 < b \leq 2$; $3 \leq c \leq 9$; $0 \leq d \leq 0,4$ et $0 \leq e \leq 0,6$.
$M^1$ peut être encore plus particulièrement l'europium.
$M^2$ peut être plus particulièrement le manganèse.

Plus particulièrement, l'aluminate de l'invention peut répondre à la formule (I) ci-dessus dans laquelle a = b = 1 et c = 5.

Selon un autre mode de réalisation particulier, l'aluminate de l'invention peut répondre à la formule (I) ci-dessus dans laquelle a = b = 1 et c = 7.

Selon encore un autre mode de réalisation particulier, l'aluminate de l'invention peut répondre à la formule (I) ci-dessus dans laquelle a = 1; b = 2 et c = 8.

On peut ainsi citer comme exemples de ce type de produits ceux de formule $BaMgAl_{10}O_{17}$, $Ba_{0,9}Eu_{0,1}MgAl_{10}O_{17}$, $Ba_{0,9}Eu_{0,1}Mg_{0,6}Mn_{0,4}Al_{10}O_{17}$; $Ba_{0,9}Eu_{0,1}Mg_{0,8}Mn_{0,2}Al_{10}O_{17}$; $Ba_{0,9}Eu_{0,1}Mg_{0,95}Mn_{0,05}Al_{10}O_{17}$; $BaMgAl_{14}O_{23}$, $Ba_{0,9}Eu_{0,1}MgAl_{14}O_{23}$, $Ba_{0,8}Eu_{0,2}Mg_{1,93}Mn_{0,07}Al_{16}O_{27}$.

L'aluminate de l'invention se présente généralement sous la forme d'une suspension dans une phase liquide des particules qui viennent d'être décrites.

Pour ce qui est des particules solides, celles-ci sont essentiellement ou uniquement constituées de l'aluminate tel que décrit ci-dessus, elles ne contiennent pas d'autres composés que cet aluminate, à l'exception par exemple d'éventuelles impuretés en quantité très réduite. L'aluminate est cristallisé sous forme essentiellement d'une alumine bêta. Cette cristallisation est mise en évidence par analyse RX. Par « essentiellement » on entend que le diagramme RX obtenu par l'analyse faite sur la poudre séchée issue de la suspension de l'invention peut présenter, outre la phase majoritaire d'alumine bêta, une ou plusieurs phases minoritaires correspondant à des impuretés telle que, par exemple, $BaAl_2O_4$. Selon un mode de réalisation préféré de l'invention, l'aluminate est cristallisé sous la forme d'une phase pure d'alumine bêta. Dans ce cas, l'analyse DRX ne fait apparaître qu'une seule phase cristallographique.

Cette suspension est stable, on entend par là que l'on n'observe pas de sédimentation des particules solides pendant plusieurs heures, par exemple sur une durée d'environ 24 heures.

On peut cependant observer au cours du temps une sédimentation qui peut entraîner une agglomération des particules entre elles. Toutefois, et cela est une propriété importante de la suspension de l'invention, une simple agitation mettant en oeuvre une énergie mécanique très faible, notamment un traitement aux ultrasons, par exemple avec une puissance de 120 W pendant 3 minutes, permet de désagglomérer ces particules et donc de revenir à une suspension dont les particules présentent toutes les caractéristiques qui ont été données plus haut.

La phase liquide des suspensions selon l'invention peut être de l'eau ou un mélange eau/solvant miscible à l'eau ou encore un solvant organique.

Le solvant organique peut être tout particulièrement un solvant miscible à l'eau. On peut citer, par exemple, les alcools comme le méthanol ou l'éthanol, les glycols comme l'éthylène glycol, les dérivés acétates des glycols comme le monoacétate d'éthylène glycol, les éthers de glycols, les polyols ou les cétones.

Cette phase liquide peut aussi comporter un dispersant.

Ce dispersant peut être choisi parmi les dispersants connus, par exemple parmi les polyphosphates ($M_{n+2}P_nO_{3n+1}$) ou les métaphosphates ($[MPO_3]_n$) alcalins (M désignant un alcalin comme le sodium), notamment comme l'héxamétaphosphate de sodium. Il peut être choisi aussi parmi les silicates alcalins (silicate de sodium), les amino-alcools, les phosphonates, l'acide citrique et ses sels, les dérivés de l'acide phosphosuccinique ($(HOOC)_n$-R-$PO_3H_2$ où R est une chaine alkyle), les acides polyacrylique, polyméthacrylique, polystyrène sulfonique et leurs sels. On préfère tout particulièrement l'acide citrique et les métaphosphates.

La quantité de dispersant peut être comprise entre 1% et 15%, plus particulièrement entre 4% et 8%, cette quantité étant exprimée en masse de dispersant par rapport à la masse de solide dans la dispersion.

La concentration de la suspension peut varier dans une large gamme. A titre d'exemple, elle peut être comprise entre environ 10 g/l et environ 500 g/l, plus particulièrement entre 40 g/l et 300 g/l, cette concentration étant exprimée en masse de solide par volume de suspension.

Pour les suspensions en phase aqueuse, et selon une variante particulière, une caractéristique intéressante de celles-ci est leur stabilité dans un domaine de pH important. Ainsi, ces suspensions restent stables, c'est-à-dire ici qu'elles ne donnent pas lieu à une sédimentation et une agglomération des particules lorsque leur pH est amené à varier entre dans des plages de valeurs données, l'ensemble de ces plages couvrant globalement des valeurs de pH qui peuvent être comprises entre 2 et 11, plus particulièrement entre 4 et 10. De telles variations de pH peuvent se produire dans la mise en oeuvre des suspensions dans des applications en luminescence et cette caractéristique est de ce fait importante car les suspensions peuvent ainsi être utilisées dans une large gamme d'applications.

L'invention concerne aussi un aluminate qui se présente sous forme solide, c'est-à-dire d'une poudre qui a pour caractéristique de pouvoir conduire à l'aluminate sous forme de suspension décrit plus haut. En d'autres termes, lorsque cette poudre est redispersée dans une phase liquide, après une simple agitation, sans qu'il soit nécessaire d'appliquer une énergie mécanique importante, notamment, là encore, par simple traitement aux ultrasons, par exemple avec une puissance de 450W environ, on obtient une suspension de l'aluminate présentant les caractéristiques données plus haut.

Le procédé de préparation de l'aluminate de l'invention sous forme de suspension va maintenant être décrit.

Ce procédé comporte une première étape dans laquelle on forme un mélange liquide qui est une solution ou une suspension ou encore un gel, des composés de l'aluminium et des autres éléments rentrant dans la composition de l'aluminate.

Comme composés de ces éléments, on utilise habituellement des sels inorganiques ou encore les hydroxydes ou les carbonates. Comme sels on peut mentionner les nitrates de préférence, notamment pour le baryum, l'aluminium, l'europium et le magnésium. Les sulfates, notamment pour l'aluminium, les chlorures ou encore les sels organiques, par exemple les acétates, peuvent éventuellement être employés.

On peut utiliser aussi comme composé de l'aluminium un sol ou une dispersion colloïdale d'aluminium. Une telle dispersion colloïdale d'aluminium peut présenter des particules ou colloïdes dont la taille est comprise entre 1nm et 300nm. L'aluminium peut être présent dans le sol sous forme de boehmite.

L'étape suivante consiste à sécher le mélange préalablement préparé. Ce séchage se fait par atomisation.

On entend par séchage par atomisation un séchage par pulvérisation du mélange dans une atmosphère chaude (spray-drying). L'atomisation peut être réalisée au moyen de tout pulvérisateur connu en soi, par exemple par une buse de pulvérisation du type pomme d'arrosoir ou autre. On peut également utiliser des atomiseurs dits à turbine. Sur les diverses techniques de pulvérisation susceptibles d'être mises en oeuvre dans le présent procédé, on pourra se référer notamment à l'ouvrage de base de MASTERS intitulé "SPRAY-DRYING" (deuxième édition, 1976, Editions George Godwin - London).

On notera que l'on peut également mettre en oeuvre l'opération d'atomisation-séchage au moyen d'un réacteur "flash", par exemple du type décrit dans les demandes de brevet français n° 2 257 326, 2 419 754 et 2 431 321. Ce type d'atomiseur peut être utilisé notamment pour préparer des produits dont la taille des particules est faible. Dans ce cas, les gaz traitants (gaz chauds) sont animés d'un mouvement hélicoïdal et s'écoulent dans un puits-tourbillon. Le mélange à sécher est injecté suivant une trajectoire confondue avec l'axe de symétrie des trajectoires hélicoïdales desdits gaz, ce qui permet de transférer parfaitement la quantité de mouvement des gaz au mélange à traiter. Les gaz assurent ainsi en fait une double fonction : d'une part la pulvérisation, c'est à dire la transformation en fines gouttelettes, du mélange initial, et d'autre part le séchage des gouttelettes obtenues. Par ailleurs, le temps de séjour extrêmement faible (généralement inférieur à 1/10 de seconde environ) des particules dans le réacteur présente pour avantage, entre autres, de limiter d'éventuels risques de surchauffe par suite d'un contact trop long avec les gaz chauds.

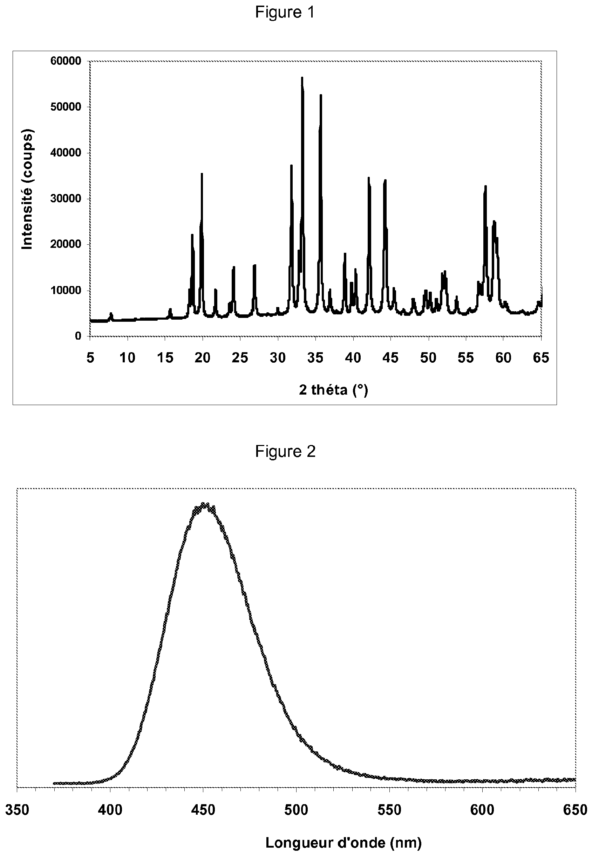

En ce qui concerne le réacteur flash mentionné plus haut, on pourra notamment se référer à la figure 1 de la demande de brevet français 2 431 321.

Celui-ci est constitué d'une chambre de combustion et d'une chambre de contact composée d'un bicône ou d'un cône tronqué dont la partie supérieure diverge. La chambre de combustion débouche dans la chambre de contact par un passage réduit.

La partie supérieure de la chambre de combustion est munie d'une ouverture permettant l'introduction de la phase combustible.

D'autre part la chambre de combustion comprend un cylindre interne coaxial, définissant ainsi à l'intérieur de celle-ci une zone centrale et une zone périphérique annulaire, présentant des perforations se situant pour la plupart vers la partie supérieure de l'appareil. La chambre comprend au minimum six perforations distribuées sur au moins un cercle, mais de préférence sur plusieurs cercles espacés axialement. La surface totale des perforations localisées dans la partie inférieure de la chambre peut être très faible, de l'ordre de 1/10 à 1/100 de la surface totale des perforations dudit cylindre interne coaxial.

Les perforations sont habituellement circulaires et présentent une épaisseur très faible. De préférence, le rapport du diamètre de celles-ci à l'épaisseur de la paroi est d'au moins 5, l'épaisseur minimale de la paroi étant seulement limitée par les impératifs mécaniques.

Enfin, un tuyau coudé débouche dans le passage réduit, dont l'extrémité s'ouvre dans l'axe de la zone centrale.

La phase gazeuse animée d'un mouvement hélicoïdal (par la suite appelée phase hélicoïdale) est composée d'un gaz, généralement de l'air, introduit dans un orifice pratiqué dans la zone annulaire, de préférence cet orifice est situé dans la partie inférieure de ladite zone.

Afin d'obtenir une phase hélicoïdale au niveau du passage réduit, la phase gazeuse est de préférence introduite à basse pression dans l'orifice précité, c'est-à-dire à une pression inférieure à 1 bar et plus particulièrement à une pression comprise entre 0,2 et 0,5 bar au-dessus de la pression existant dans la chambre de contact. La vitesse de cette phase hélicoïdale est généralement comprise entre 10 et 100 m/s et de préférence entre 30 et 60 m/s.

Par ailleurs, une phase combustible qui peut être notamment du méthane, est injectée axialement par l'ouverture précitée dans la zone centrale à une vitesse d'environ 100 à 150 m/s.

La phase combustible est enflammée par tout moyen connu, dans la région où le combustible et la phase hélicoïdale sont en contact.

Par la suite, le passage imposé des gaz dans le passage réduit se fait suivant un ensemble de trajectoires confondues avec des familles de génératrices d'un hyperboloïde. Ces génératrices reposent sur une famille de cercles, d'anneaux de petite taille localisés près et au-dessous du passage réduit, avant de diverger dans toutes les directions.

On introduit ensuite le mélange à traiter sous forme de liquide par le tuyau précité. Le liquide est alors fractionné en une multitude de gouttes, chacune d'elle étant transportée par un volume de gaz et soumise à un mouvement créant un effet centrifuge. Habituellement, le débit du liquide est compris entre 0,03 et 10 m/s.

Le rapport entre la quantité de mouvement propre de la phase hélicoïdale et celle du mélange liquide doit être élevé. En particulier il est d'au moins 100 et de préférence compris entre 1000 et 10000. Les quantités de mouvement au niveau du passage réduit sont calculées en fonction des débits d'entrée du gaz et du mélange à traiter, ainsi que de la section dudit passage. Une augmentation des débits entraîne un grossissement de la taille des gouttes.

Dans ces conditions, le mouvement propre des gaz est imposé dans sa direction et son intensité aux gouttes du mélange à traiter, séparées les unes des autres dans la zone de convergence des deux courants. La vitesse du mélange liquide est de plus réduite au minimum nécessaire pour obtenir un flot continu.

L'atomisation se fait avec une température de sortie du solide comprise entre 100°C et 300°C.

L'étape suivante du procédé consiste à calciner le produit obtenu à l'issue du séchage.

Cette calcination se fait à une température qui est suffisamment élevée pour obtenir une phase cristalline. Cette température est d'au moins 1100°C, plus particulièrement d'au moins 1200 °C. Elle peut être d'au plus 1500°C et par exemple être comprise entre 1200°C et 1400°C.

Cette calcination se fait sous air ou, notamment dans le cas où l'aluminate contient un dopant et pour des utilisations de cet aluminate comme luminophore, sous atmosphère réductrice par exemple sous hydrogène en mélange dans l'azote ou l'argon. La durée de cette calcination est par exemple comprise entre 30 minutes et 10 heures environ. Il est possible de faire deux calcinations, la première sous air et la seconde sous atmosphère réductrice.

Dans certains cas, en fonction du type des composés de départ choisis de l'aluminium et des autres éléments, il peut être avantageux de faire une calcination préliminaire à celle ou à celles qui a ou ont été mentionnées ci-dessus, à une température un peu plus faible que celles donnée ci-dessus, par exemple en dessous de 1000°C.

La dernière étape du procédé consiste à broyer le produit issu de la calcination. Selon l'invention on effectue un broyage humide dans l'eau ou encore dans un mélange eau/solvant ou dans un solvant organique du même type que les solvants qui ont été décrits plus haut pour la phase liquide constitutive de la suspension.

On peut utiliser pendant le broyage un dispersant du type de ceux décrits plus haut et dans les quantités données précédemment. Ce dispersant peut contribuer à la stabilité de la suspension obtenue dans différents domaines de pH comme décrit plus haut, un dispersant donné entrainant une stabilité dans une plage donnée de pH.

Le broyage humide se fait dans des conditions qui sont par ailleurs bien connues de l'homme du métier.

A l'issue du broyage humide on obtient l'aluminate de l'invention sous forme d'une suspension.

On notera que dans le cas d'une suspension dans un mélange eau/solvant ou dans un solvant organique, cette suspension peut être préparée à partir d'une suspension aqueuse telle qu'obtenue par le procédé qui vient d'être décrit et par addition du solvant organique à cette suspension aqueuse puis, si nécessaire, distillation pour éliminer l'eau.

La description qui vient d'être faite concerne la préparation de l'aluminate sous forme d'une suspension. Pour obtenir l'aluminate de l'invention sous forme d'une poudre, on part de cette suspension et on sépare le produit solide de la phase liquide en utilisant toute technique de séparation connue par exemple par filtration. Le produit solide ainsi obtenu peut être séché éventuellement puis remis en suspension dans une phase liquide du même type que celle décrite plus haut.

De par leurs propriétés et la nature des substituants ou dopants, les aluminates de l'invention, on entend par là les aluminates sous forme d'une suspension ou les aluminates sous forme solide, peuvent être utilisés comme luminophores.

Plus précisément, ces aluminates présentent des propriétés de luminescence sous une excitation électromagnétique dans le domaine des longueurs d'onde utilisées dans les systèmes à plasma (écrans et lampes où l'excitation est créée par un gaz rare ou un mélange de gaz rare comme le xénon ou/et le néon), dans les lampes à vapeur de mercure et dans les diodes électroluminescentes (LED). De ce fait, ils peuvent être utilisés comme luminophores dans les systèmes à plasma (écran de visualisation ou système d'éclairage),dans les lampes à vapeur de mercure et les diodes LED.

L'invention concerne donc aussi les dispositifs luminescents comprenant l'aluminate décrit plus haut ou tel qu'obtenu par le procédé décrit ci-dessus ou fabriqués en utilisant ce même aluminate. De même, l'invention concerne les systèmes à plasma, les lampes à vapeur de mercure ou les diodes LED, dans la fabrication desquels l'aluminate peut rentrer, ou comprenant ce même aluminate. La mise en oeuvre des luminophores dans ces fabrications se fait selon des techniques bien connues par exemple par sérigraphie, électrophorèse, sédimentation, jet d'encre, pulvérisation, « spin-coating » ou « dip-coating ».

Les propriétés granulométriques des aluminates de l'invention font qu'ils peuvent être utilisés comme marqueurs dans des encres semi-transparentes, par exemple pour la réalisation d'un marquage par un système de code à barres invisible.

Les aluminates de l'invention peuvent aussi être utilisés comme marqueurs dans un matériau du type papier, carton, textile, verre ou encore un matériau macromoléculaire. Celui-ci peut être de différentes natures : élastomérique, thermoplastique, thermodurcissable.

D'autre part, les propriétés particulières de ces aluminates, quand ils ne sont pas dopés, (pas d'absorption dans le domaine visible et UV), font qu'ils peuvent être utilisés comme barrière réfléchissante dans les systèmes d'éclairage à vapeur de mercure.

L'invention concerne aussi un matériau luminescent qui comprend, ou qui peut être fabriqué en utilisant au moins un aluminate selon l'invention ou un aluminate obtenu par le procédé tel que décrit plus haut.

Selon un mode de réalisation préférentiel, ce matériau luminescent peut être en outre transparent. Dans ce cas, l'aluminate rentrant dans sa composition ou dans sa fabrication est un aluminate selon l'invention et de taille moyenne comprise entre 100 nm et 150 nm.

On notera que ce matériau peut comprendre, ou être fabriqué en utilisant, outre l'aluminate de l'invention, d'autres aluminates, ou plus généralement, d'autres luminophores, sous forme de particules submicroniques ou nanométriques.

Ce matériau peut se présenter sous deux formes, c'est à dire soit sous une forme massique, l'ensemble du matériau présentant les propriétés de transparence et de luminescence soit sous une forme composite, c'est à dire dans ce cas sous la forme d'un substrat et d'une couche sur ce substrat, la couche présentant seule alors ces propriétés de transparence et de luminescence. Dans ce cas, l'aluminate de l'invention est contenu dans ladite couche.

Le substrat du matériau est un substrat qui peut être en silicium, à base d'un silicone ou en quartz. Ce peut être aussi un verre ou encore un polymère comme le polycarbonate. Le substrat, par exemple le polymère, peut se présenter sous une forme rigide ou sous forme flexible comme une feuille ou une plaque de quelques millimètres d'épaisseur. Il peut aussi se présenter sous forme d'un film de quelques dizaines de microns voire quelques microns à quelques dixièmes de millimètre d'épaisseur.

Par matériau transparent on entend au sens de l'invention un matériau qui présente un trouble (haze) d'au plus 60% et une transmission totale d'au moins 60% et, de préférence, un trouble (haze) d'au plus 40% et une transmission totale d'au moins 80%. La transmission totale correspond à quantité de lumière totale qui traverse la couche, par rapport à la quantité de lumière incidente. Le trouble (haze) correspond au rapport de la transmission diffuse de la couche à sa transmission totale.

Ces deux grandeurs sont mesurées dans les conditions suivantes : la couche de matériau d'épaisseur comprise entre 0,2 $\mu$m et 1 $\mu$m est déposée sur un substrat de verre standard, d'épaisseur 0,5 mm. La fraction massique en particules d'aluminate dans le matériau est d'au moins 20%. Les mesures de la transmission totale et de la transmission diffuse s'effectuent à travers la couche du matériau et du substrat, au moyen d'une procédure classique sur un spectromètre Perkin Elmer Lamda 900, équipé d'une sphère d'intégration, pour une longueur d'onde de 550 nm.

Le matériau, et plus particulièrement la couche précitée, peut comprendre, outre un aluminate selon l'invention, des liants ou des charges du type polymère (polycarbonate, méthacrylate), silicate, billes de silice, phosphate, oxyde de titane ou autres charges minérales pour améliorer notamment les propriétés mécaniques et optiques du matériau.

La fraction massique en particules d'aluminate dans le matériau peut être comprise entre 20% et 99%.

L'épaisseur de la couche peut être comprise entre 30 nm et 10 $\mu$m, de préférence entre 100 nm et 3 $\mu$m et encore plus préférentiellement entre 100 nm et 1 $\mu$m.

Le matériau, sous sa forme composite, peut être obtenu par dépôt sur le substrat, éventuellement préalablement lavé par exemple par un mélange sulfo-chromique, d'une suspension d'aluminate de l'invention. On peut aussi ajouter au moment de ce dépôt, les liants ou charges mentionnés plus haut. Ce dépôt peut être réalisé par une technique de pulvérisation, de « spin-coating » ou de « dip-coating ». Après dépôt de la couche, le substrat est séché à l'air et il peut éventuellement ensuite subir un traitement thermique. Le traitement thermique est réalisé par un chauffage à une température qui généralement est d'au moins 200°C et dont la valeur supérieure est fixée notamment en tenant compte de la compatibilité de la couche avec le substrat de manière à éviter notamment des réactions parasites. Le séchage et le traitement thermique peuvent être conduits sous air, sous atmosphère inerte, sous vide ou encore sous hydrogène.

On a vu plus haut que le matériau peut comprendre des liants ou des charges. Il est possible dans ce cas d'utiliser des suspensions qui comprennent elles-mêmes au moins un de ces liants ou de ces charges ou encore des précurseurs de ceux-ci.

Le matériau selon la forme massique peut être obtenu par incorporation des particules d'aluminate dans une matrice de type polymère par exemple, comme du polycarbonate, du polyméthacrylate ou un silicone.

L'invention concerne enfin un système luminescent qui comprend un matériau du type décrit ci - dessus et, en outre, une source d'excitation qui peut être une source de photons UV, comme une diode UV ou encore une excitation de type Hg, gaz rares ou rayons X.

Le système peut être utilisé comme dispositif d'éclairage mural transparent, du type vitrage éclairant.

Des exemples vont maintenant être donnés. Les exemples 2, 3, 5 et 6 ne font pas partie de l'invention telle qu'elle est définie aux revendications 1 à 6.

EXEMPLE 1

Cet exemple concerne la préparation d'une suspension d'un aluminate de baryum et de magnésium de formule $Ba_{0,9}Eu_{0,1}MgAl_{10}O_{17}$, selon l'invention.

Une solution est constituée par un mélange de nitrates de baryum, de magnésium et d'europium, de composition suivante (en % atomique) :

    Ba : 45%
    Mg : 50%
    Eu : 5%

Par ailleurs, un sol de boehmite (surface spécifique de 265 $m^2$/g) est fabriqué, avec une concentration en Al d'environ 1,8 mol/l. La solution de nitrates et le sol de boehmite sont mélangés pour obtenir un gel présentant les ratios molaires suivants :

    Ba/Al : 0,09
    Mg/Al : 0,1
    Eu/Al : 0,01

De l'eau est ajoutée à ce gel, pour obtenir une concentration en Al d'environ 0,7 mol/l. Le gel ainsi obtenu présente un pH final de 3,5. Le gel est séché sur un atomiseur du type flash tel que décrit plus haut et dans FR 2431321 A1, avec une température de 180°C en sortie. La poudre séchée est alors calcinée sous air à 900°C pendant 2 heures, puis sous un mélange Ar/$H_2$ (95/5) à 1400°C pendant 2 heures.

On fait subir à la poudre obtenue un broyage humide dans un broyeur à billes Netzch Labstar, avec des billes de 0,4-0,8 mm en $ZrO_2$-$SiO_2$. Le taux d'occupation des billes dans la chambre de broyage est de 70%. La concentration de la suspension est de 20% massique en solide et un dispersant, l'hexamétaphosphate de sodium (HMP), est ajouté à un taux de 0,025 g de HMP/g poudre (soit 2,5% massique). Le broyeur est utilisé en recirculation, avec une vitesse de rotation de 3000 t/min. Le broyage dure 90 minutes.

L'analyse par granulométrie laser, sans ultrasons, de la suspension obtenue donne les résultats suivants :

| | |
|---|---|
| $d_{16}$ (nm) | 70 |
| $d_{50}$ (nm) | 138 |
| $d_{84}$ (nm) | 240 |
| $\sigma$/m | 0,6 |

Comme cela apparaît de la figure 1, l'analyse de l'échantillon obtenu par séchage de la suspension à 100°C à l'étuve par diffraction des rayons X révèle une phase alumine bêta, avec une taille de domaine cohérent calculé à partir de la raie de diffraction correspondant au plan cristallographique [102] de 101 nm.

On constate que la valeur du $d_{50}$ (laser) et celle de la taille du domaine cohérent (DRX) présentent le même ordre de grandeur, ce qui confirme le caractère monocristallin des particules.

La suspension obtenue émet dans le bleu (450 nm) sous excitation à 254 nm. La figure 2 est le spectre d'émission de cette suspension.

EXEMPLE 2

Cet exemple concerne la préparation d'une suspension d'un aluminate de baryum et de magnésium de formule $Ba_{0,9}Eu_{0,1}MgAl_{10}O_{17}$, selon l'invention.

La préparation est identique à celle de l'exemple 1, jusqu'à la calcination à 1400°C.

On fait subir à la poudre obtenue un broyage humide dans un broyeur bol à billes Molinex, avec des billes de 0,4-0,6 mm en $ZrO_2$-$SiO_2$. Le taux d'occupation des billes dans la chambre de broyage est de 65%. La concentration de la suspension est de 20% massique en solide et un dispersant, le citrate de sodium, est ajouté à un taux de 0,05 g de citrate de Na/g poudre (soit 5% massique). La vitesse de rotation du mobile est de 1000 t/min. Le broyage dure 95 minutes.

L'analyse par granulométrie laser, sans ultrasons, de la suspension obtenue donne les résultats suivants :

| | |
|---|---|
| $d_{16}$ (nm) | 75 |
| $d_{50}$ (nm) | 158 |
| $d_{84}$ (nm) | 310 |
| $\sigma/m$ | 0,75 |

L'analyse de l'échantillon obtenu par séchage de la suspension à 100°C à l'étuve par diffraction des rayons X révèle une phase alumine bêta, avec une taille de domaine cohérent calculé à partir de la raie de diffraction correspondant au plan cristallographique [102] de 119 nm.

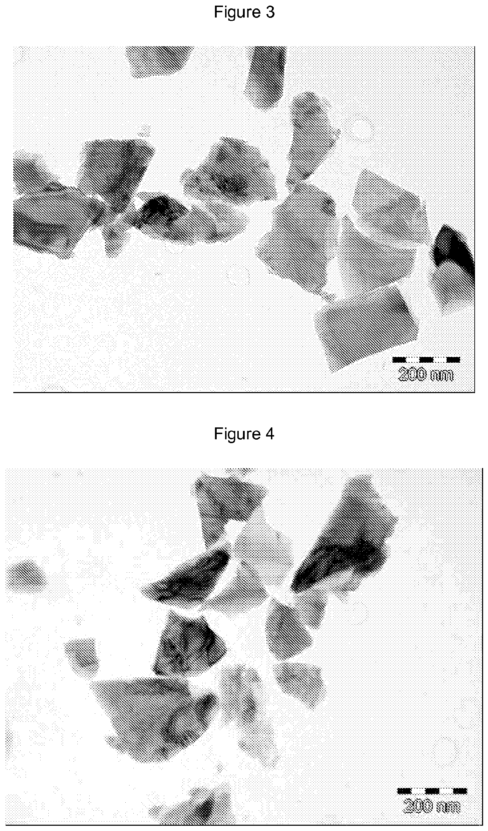

On constate que la valeur du $d_{50}$ (laser) et celle de la taille du domaine cohérent présentent le même ordre de grandeur, ce qui confirme le caractère monocristallin des particules. Par ailleurs, la figure 3 est une photo MET de la suspension issue du broyage. Cette photo montre le caractère monocristallin des particules.

La suspension obtenue émet dans le bleu (450 nm) sous excitation à 254 nm.

EXEMPLE 3

Cet exemple concerne la préparation d'une suspension d'un aluminate de baryum et de magnésium de formule $Ba_{0,9}Eu_{0,1}MgAl_{10}O_{17}$, selon l'invention.

La préparation est identique à celle de l'exemple 1, jusqu'à la calcination à 1400°C.

On fait subir à la poudre obtenue un broyage humide dans un broyeur bol à billes Molinex, avec des billes de 0,4-0,6 mm en $ZrO_2$-$SiO_2$. Le taux d'occupation des billes dans la chambre de broyage est de 65%. La concentration de la suspension est de 20 % massique en solide et un dispersant, l'acide phosphosuccinique, est ajouté à un taux de 0,09 g d'acide phosphosuccinique/g poudre (soit 9 % massique). La vitesse de rotation du mobile est de 1000 t/min. Le broyage dure 150 minutes.

L'analyse par granulométrie laser, sans ultrasons, de la suspension obtenue donne les résultats suivants :

| | |
|---|---|
| $d_{16}$ (nm) | 90 |
| $d_{50}$ (nm) | 227 |
| $d_{84}$ (nm) | 465 |
| $\sigma/m$ | 0,8 |

La figure 4 est une photo MET de la suspension issue du broyage qui fait apparaître le caractère monocristallin des particules.

La suspension obtenue émet dans le bleu (450 nm) sous excitation à 254 nm.

EXEMPLE 4

On procède comme dans l'exemple 1 jusqu'à l'obtention d'un gel présentant un pH final de 3,5. Le gel est séché sur un atomiseur de type APV®, avec une température de 145°C en sortie. La poudre séchée est alors calcinée sous air à 900°C pendant 2 heures, puis sous un mélange Ar/H$_2$ (95/5) à 1400°C pendant 2 heures.

On fait subir à la poudre obtenue un broyage humide dans un broyeur bol à billes Molinex, avec des billes de 1,6-2,5 mm en $ZrO_2$-$SiO_2$. Le taux d'occupation des billes dans la chambre de broyage est de 65%. La concentration de la suspension est de 50% massique en solide et un dispersant, l'hexamétaphosphate de sodium (HMP) est ajouté à un taux de 0,05 g de HMP/g poudre (soit 5 % massique). La vitesse de rotation du mobile est de 1800 t/min. Le broyage dure 240 minutes.

Suite à ce broyage humide, un second broyage est effectué sur la suspension avec des billes de 0,2-0,3 mm en $ZrO_2$-$SiO_2$ pendant 45 minutes, sans modifier les autres paramètres de broyage.

L'analyse par granulométrie laser, sans ultrasons, de la suspension obtenue donne les résultats suivants :

| | |
|---|---|
| $d_{16}$ (nm) | 80 |
| $d_{50}$ (nm) | 145 |
| $d_{84}$ (nm) | 290 |

(suite)

| | |
|---|---|
| σ/m | 0,7 |

L'analyse de l'échantillon obtenu par séchage de la suspension à 100°C à l'étuve par diffraction des rayons X révèle une phase alumine bêta, avec une taille de domaine cohérent calculé à partir de la raie de diffraction correspondant au plan cristallographique [102] de 100 nm.

On constate que la valeur du $d_{50}$ (laser) et celle de la taille du domaine cohérent présentent le même ordre de grandeur, ce qui confirme le caractère monocristallin des particules.

La suspension obtenue émet dans le bleu (450 nm) sous excitation à 254 nm.

EXEMPLE 5

Cet exemple concerne la préparation d'une suspension d'un aluminate de baryum et de magnésium de formule $Ba_{0,9}Eu_{0,1}Mg_{0,95}Mn_{0,05}Al_{10}O_{17}$, selon l'invention.

Une solution est constituée par un mélange de nitrates de baryum, de magnésium, d'europium et de manganèse, de composition suivante (en % atomique) :

Ba : 45%

Mg : 47,5%

Eu : 5%

Mn : 2,5%

Par ailleurs, un sol de boehmite (surface spécifique de 265 $m^2$/g) est fabriqué, avec une concentration en Al d'environ 1,8 mol/l. La solution de nitrates et le sol de boehmite sont mélangés pour obtenir un gel présentant les ratios molaires suivants :

Ba/Al : 0,09
Mg/Al : 0,095
Eu/Al : 0,01
Mn/Al : 0,005

De l'eau est ajoutée à ce gel, pour obtenir une concentration en Al d'environ 0,7 mol/l. Le gel ainsi obtenu présente un pH final de 3,5. Le gel est séché sur un équipement identique à celui de l'exemple 1 avec une température de 180°C en sortie. La poudre séchée est alors calcinée sous air à 900°C pendant 2 heures, puis sous un mélange Ar/$H_2$ (95/5) à 1400°C pendant 2 heures.

On fait subir à la poudre obtenue un broyage humide dans un broyeur bol à billes Molinex, avec des billes de 1,6-2,5 mm en $ZrO_2$-$SiO_2$. Le taux d'occupation des billes dans la chambre de broyage est de 65%. La concentration de la suspension est de 50% massique en solide et un dispersant, l'hexamétaphosphate de sodium (HMP) est ajouté à un taux de 0,075 g de HMP/g poudre (soit 7,5 % massique). La vitesse de rotation du mobile est de 1800 t/min. Le broyage dure 360 minutes.

Suite à ce broyage humide, un second broyage est effectué sur la suspension avec des billes de 0,2-0,3 mm en $ZrO_2$-$SiO_2$. Les autres paramètres du broyage ne changent pas, et le temps de broyage est de 215 minutes.

L'analyse par granulométrie laser, sans ultrasons, de la suspension obtenue donne les résultats suivants :

| | |
|---|---|
| $d_{16}$ (nm) | 90 |
| $d_{50}$ (nm) | 166 |
| $d_{84}$ (nm) | 360 |
| σ/m | 0,8 |

L'analyse de l'échantillon obtenu par séchage de la suspension à 100°C à l'étuve par diffraction des rayons X révèle une phase alumine bêta, avec une taille de domaine cohérent calculé à partir de la raie de diffraction correspondant au plan cristallographique [102] de 110 nm.

On constate que la valeur du $d_{50}$ (laser) et celle de la taille du domaine cohérent présentent le même ordre de grandeur, ce qui confirme le caractère monocristallin des particules.

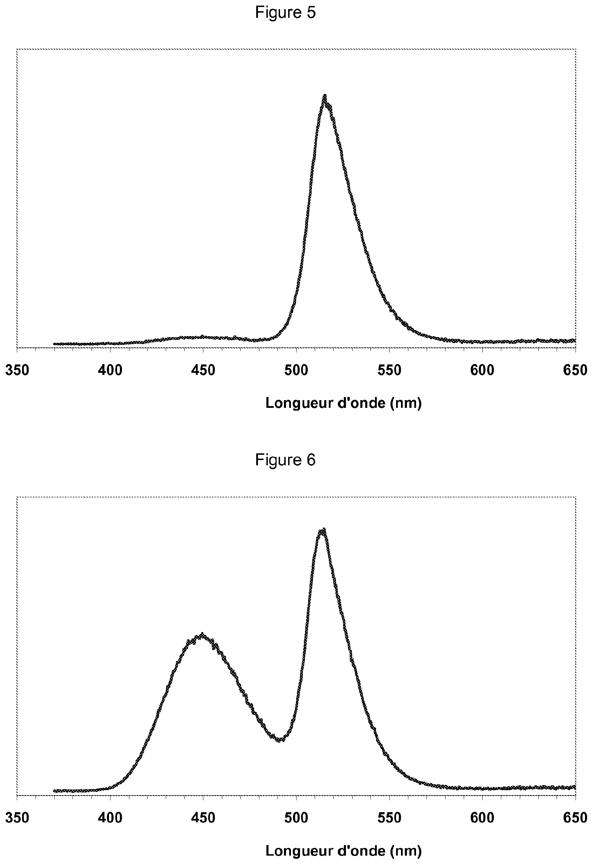

Le produit obtenu émet dans le bleu (450 nm) et le vert (515 nm) sous excitation à 254 nm. La figure 5 est le spectre d'émission de cette suspension.

EXEMPLE 6

Cet exemple concerne la préparation d'une suspension d'un aluminate de baryum et de magnésium de formule $Ba_{0,9}Eu_{0,1}Mg_{0,6}Mn_{0,4}Al_{10}O_{17}$, selon l'invention.

Une solution est constituée par un mélange de nitrates de baryum, de magnésium, d'europium et de manganèse, de composition suivante (en % atomique) :

Ba : 45%
Mg : 30%
Eu : 5%
Mn : 20%

Par ailleurs, un sol de boehmite (surface spécifique de 265 m$^2$/g) est fabriqué, avec une concentration en Al d'environ 1,8 mol/l. La solution de nitrates et le sol de boehmite sont mélangés pour obtenir un gel présentant les ratios molaires suivants :

Ba/Al : 0,09
Mg/Al : 0,06
Eu/Al : 0,01
Mn/Al : 0,04

De l'eau est ajoutée à ce gel, pour obtenir une concentration en Al d'environ 0,7 mol/l. Le gel ainsi obtenu présente un pH final de 3,5. Le gel est séché sur un équipement identique à celui de l'exemple 1 avec une température de 180°C en sortie. La poudre séchée est alors calcinée sous air à 900°C pendant 2 heures, puis sous un mélange Ar/H$_2$ (95/5) à 1400°C pendant 2 heures.

On fait subir à la poudre obtenue un broyage humide dans un broyeur bol à billes Molinex, avec des billes de 1,6-2,5 mm en ZrO$_2$-SiO$_2$. Le taux d'occupation des billes dans la chambre de broyage est de 65%. La concentration de la suspension est de 50% massique en solide et un dispersant, l'hexamétaphosphate de sodium (HMP) est ajouté à un taux de 0,075 g de HMP/g poudre (soit 7,5 % massique). La vitesse de rotation du mobile est de 1800 t/min. Le broyage dure 420 minutes.

Suite à ce broyage humide, un second broyage est effectué sur la suspension avec des billes de 0,2-0,3 mm en ZrO$_2$-SiO$_2$. Les autres paramètres du broyage ne changent pas et le temps de broyage est de 200 minutes.

L'analyse par granulométrie laser, sans ultrasons, de la suspension obtenue donne les résultats suivants :

| | |
|---|---|
| $d_{16}$ (nm) | 80 |
| $d_{50}$ (nm) | 160 |
| $d_{84}$ (nm) | 340 |
| $\sigma/m$ | 0,8 |

L'analyse de l'échantillon obtenu par séchage de la suspension à 100°C à l'étuve par diffraction des rayons X révèle une phase alumine bêta, avec une taille de domaine cohérent calculé à partir de la raie de diffraction correspondant au plan cristallographique [102] de 89 nm.

On constate que la valeur du $d_{50}$ (laser) et celle de la taille du domaine cohérent présentent le même ordre de grandeur, ce qui confirme le caractère monocristallin des particules.

Le produit obtenu émet dans le bleu (450 nm) et le vert (515 nm) sous excitation à 254 nm. La figure 6 est le spectre d'émission de cette suspension.

**Revendications**

1. Suspension d'aluminate de baryum et de magnésium, **caractérisée en ce qu'**elle se présente sous forme de particules substantiellement monocristallines dans une phase liquide, les particules présentant une taille moyenne $d_{50}$ comprise entre 100 et 150 nm ainsi qu'un indice de dispersion $\sigma/m$ d'au plus 1, $\sigma/m$ étant défini par le rapport :

$$\sigma/m = (d_{84}-d_{16})/2d_{50}$$

dans lequel :

- $d_{84}$ est le diamètre des particules pour lequel 84% des particules ont un diamètre inférieur à $d_{84}$ ;
- $d_{16}$ est le diamètre des particules pour lequel 16% des particules ont un diamètre inférieur à $d_{16}$;
- $d_{50}$ est le diamètre moyen des particules ;

la taille moyenne $d_{50}$ et l'indice de dispersion étant déterminés à l'aide d'un granulomètre laser en utilisant une répartition en volume.

2. Suspension selon la revendication 1, **caractérisée en ce que** les particules se présentent sous une forme telle que le rapport de la taille moyenne desdites particules, mesurée par la technique de diffraction laser à la taille moyenne de ces mêmes particules mesurée par diffraction des rayons X est inférieur à 2, plus particulièrement est d'au plus 1,5.

3. Suspension selon l'une des revendications précédentes, **caractérisée en ce que** les particules présentent un indice de dispersion d'au plus 0,7.

4. Suspension selon l'une des revendications précédentes, **caractérisée en ce que** l'aluminate de baryum et de magnésium est cristallisé sous forme d'une phase pure.

5. Suspension selon l'une des revendications précédentes, **caractérisée en ce que** l'aluminate de baryum et de magnésium répond à la formule (I)

$$a(Ba_{1-d}M^1_dO).b(Mg_{1-e}M^2_eO).c(Al_2O_3)$$

dans laquelle :

$M^1$ désigne une terre rare qui peut être plus particulièrement le gadolinium, le terbium, l'yttrium, l'ytterbium, l'europium, le néodyme et le dysprosium;
$M^2$ désigne le zinc, le manganèse ou le cobalt;
a, b, c, d et e vérifient les relations :
$0,25 \leq a \leq 2; 0 < b \leq 2; 3 \leq c \leq 9; 0 \leq d \leq 0,4$ et $0 \leq e \leq 0,6$.

6. Suspension selon la revendication 5, **caractérisée en ce que** l'aluminate de baryum et de magnésium répond à la formule (I) précitée dans laquelle a = b = 1 et c = 5; ou a = b = 1 et c = 7 ou encore a = 1; b = 2 et c = 8.

7. Procédé de préparation d'une suspension de particules substantiellement monocristallines d'aluminate de baryum et de magnésium dans une phase liquide, les particules présentant une taille moyenne $d_{50}$ comprise entre 80 nm et 200 nm, la taille moyenne $d_{50}$ étant déterminée à l'aide d'un granulomètre laser en utilisant une répartition en volume,
**caractérisé en ce qu'**il comprend les étapes suivantes :

- on forme un mélange liquide comportant des composés de l'aluminium et des autres éléments rentrant dans la composition de l'aluminate ;
- on sèche par atomisation ledit mélange, le mélange étant pulvérisé dans une atmosphère chaude, la température de sortie du solide étant comprise entre 100°C et 300°C ;
- on calcine le produit séché à une température d'au moins 1100°C soit sous air soit sous atmosphère réductrice ;

cette étape de calcination pouvant être précédée d'une calcination préliminaire à une température en-dessous de 1000°C ;

- on effectue un broyage humide du produit issu de la calcination.

**8.** Procédé selon la revendication 7, **caractérisé en ce qu'**on effectue deux calcinations, la première sous air et la seconde sous atmosphère réductrice.

**9.** Procédé selon la revendication 7 ou 8 **caractérisé en ce qu'**on utilise comme composé de l'aluminium un sol de cet élément.

**10.** Procédé selon l'une des revendications 7 à 8, **caractérisé en ce qu'**on utilise des nitrates comme composés de l'aluminium et des éléments précités.

**11.** Procédé selon l'une des revendications 7 à 10, **caractérisé en ce que** l'aluminate de baryum et de magnésium répond à la formule (I)

$$a(Ba_{1-d}M^1_dO).b(Mg_{1-e}M^2O).c(Al_2O_3)$$

dans laquelle :

M$^1$ désigne une terre rare qui peut être plus particulièrement le gadolinium, le terbium, l'yttrium, l'ytterbium, l'europium, le néodyme et le dysprosium;
M$^2$ désigne le zinc, le manganèse ou le cobalt;
a, b, c, d et e vérifient les relations :
$0,25 \leq a \leq 2; 0 < b \leq 2; 3 \leq c \leq 9; 0 \leq d \leq 0,4$ et $0 \leq e \leq 0,6$.

**12.** Procédé selon la revendication 11, **caractérisée en ce que** l'aluminate de baryum et de magnésium répond à la formule (I) précitée dans laquelle a = b = 1 et c = 5; ou a = b = 1 et c = 7 ou encore a = 1; b = 2 et c = 8.

**13.** Dispositif du type système à plasma, lampe à vapeur de mercure ou diode électroluminescente, **caractérisé en ce qu'**il comprend, ou **en ce qu'**il est fabriqué en utilisant une suspension d'aluminate selon l'une des revendications 1 à 6 ou une suspension d'aluminate obtenue par le procédé selon l'une des revendications 7 à 12.

**14.** Matériau luminescent, **caractérisé en ce qu'**il comprend une matrice de type polymère dans laquelle sont incorporées des particules d'aluminate et qui a été fabriqué en utilisant une suspension d'aluminate selon l'une des revendications 1 à 6 ou une suspension d'aluminate obtenue par le procédé selon l'une des revendications 7 à 12.

**15.** Matériau luminescent comprenant un substrat et une couche sur ce substrat, **caractérisé en ce qu'**il a été obtenu par dépôt sur le substrat d'une suspension d'aluminate selon l'une des revendications 1 à 6 ou une suspension d'aluminate obtenue par le procédé selon l'une des revendications 7 à 12.

**16.** Matériau selon la revendication 14, **caractérisé en ce qu'**il est transparent et présente un trouble (haze) d'au plus 60% et une transmission totale d'au moins 60% et **en ce que** l'aluminate précité présente une taille moyenne de particules comprise entre 100 nm et 200 nm.

**17.** Système luminescent, **caractérisé en ce qu'**il comprend un matériau selon la revendication 14 ou 15 et en outre une source d'excitation.

**Patentansprüche**

**1.** Suspension von Bariummagnesiumaluminat, **dadurch gekennzeichnet, dass** sie in Form von weitgehend einkristallinen Teilchen in einer flüssigen Phase vorliegt, wobei die Teilchen eine mittlere Größe $d_{50}$ zwischen 100 und 150 nm sowie einen Dispersionsindex $\sigma/m$ von höchstens 1 aufweisen, wobei $\sigma/m$ durch das Verhältnis

$$\sigma/m = (d_{84}-d_{16})/2d_{50}$$

definiert ist, wobei:

- $d_{84}$ der Durchmesser der Teilchen ist, für den 84 % der Teilchen einen Durchmesser von weniger als $d_{84}$ haben;
- $d_{16}$ der Durchmesser der Teilchen ist, für den 16 % der Teilchen einen Durchmesser von weniger als $d_{16}$ haben;
- $d_{50}$ der mittlere Durchmesser der Teilchen ist;

wobei die mittlere Größe $d_{50}$ und der Dispersionsindex mit Hilfe eines Laserteilchengrößenbestimmungsgeräts unter Verwendung einer Volumenverteilung gemessen werden.

2. Suspension nach Anspruch 1, **dadurch gekennzeichnet, dass** die Teilchen in einer solchen Form vorliegen, dass das Verhältnis der nach der Laserbeugungstechnik gemessenen mittleren Größe der Teilchen zu der durch Röntgenbeugung gemessenen mittleren Größe derselben Teilchen weniger als 2 und spezieller höchstens 1,5 beträgt.

3. Suspension nach einem der vorhergehenden Ansprüche, **dadurch gekennzeichnet, dass** die Teilchen einen Dispersionsindex von höchstens 0,7 aufweisen.

4. Suspension nach einem der vorhergehenden Ansprüche, **dadurch gekennzeichnet, dass** das Bariummagnesiumaluminat in Form einer reinen Phase kristallisiert ist.

5. Suspension nach einem der vorhergehenden Ansprüche, **dadurch gekennzeichnet, dass** das Bariummagnesiumaluminat der Formel (I) entspricht:

$$a(Ba_{1-d}M^1_dO).b(Mg_{1-e}M^2_eO).c(Al_2O_3),$$

wobei:

$M^1$ für ein Seltenerdmetall steht, bei dem es sich spezieller um Gadolinium, Terbium, Yttrium, Ytterbium, Europium, Neodym und Dysprosium handeln kann;
$M^2$ für Zink, Mangan oder Cobalt steht;
a, b, c, d und e die folgenden Bedingungen erfüllen:
$0,25 \leq a \leq 2$; $0 < b \leq 2$; $3 \leq c \leq 9$; $0 \leq d \leq 0,4$ und $0 \leq e \leq 0,6$.

6. Suspension nach Anspruch 5, **dadurch gekennzeichnet, dass** das Bariummagnesiumaluminat der obigen Formel (I) entspricht, wobei a = b = 1 und c = 5 oder a = b = 1 und c = 7 oder auch a = 1, b = 2 und c = 8.

7. Verfahren zur Herstellung einer Suspension von weitgehend einkristallinen Teilchen von Bariummagnesiumaluminat in flüssiger Phase, wobei die Teilchen eine mittlere Größe $d_{50}$ zwischen 80 nm und 200 nm aufweisen, wobei die mittlere Größe $d_{50}$ mit Hilfe eines Laserteilchengrößenbestimmungsgeräts unter Verwendung einer Volumenverteilung gemessen wird,
**dadurch gekennzeichnet, dass** es die folgenden Schritte umfasst:

- es wird eine flüssige Mischung gebildet, die Verbindungen von Aluminium und den anderen Elementen, die in der Zusammensetzung des Aluminats enthalten sind, umfasst;
- die Mischung wird sprühgetrocknet, wobei die Mischung in einer heißen Atmosphäre versprüht wird, wobei die Feststoff-Ausgangstemperatur zwischen 100 °C und 300 °C liegt;
- das getrocknete Produkt wird bei einer Temperatur von mindestens 1100 °C entweder an der Luft oder in einer reduzierenden Atmosphäre calciniert;

wobei diesem Calcinierungsschritt eine Vorcalcinierung bei einer Temperatur unterhalb von 1000 °C vorhergehen kann;

- es wird eine Nassmahlung des Produkts aus der Calcinierung durchgeführt.

8. Verfahren nach Anspruch 7, **dadurch gekennzeichnet, dass** zwei Calcinierungen durchgeführt werden, die erste an der Luft und die zweite in reduzierender Atmosphäre.

9. Verfahren nach Anspruch 7 oder 8, **dadurch gekennzeichnet**, das als Aluminiumverbindung ein Sol dieses Elements verwendet wird.

10. Verfahren nach einem der Ansprüche 7 bis 8, **dadurch gekennzeichnet, dass** als Verbindungen von Aluminium und den obigen Elementen Nitrate verwendet werden.

11. Verfahren nach einem der Ansprüche 7 bis 10, **dadurch gekennzeichnet, dass** das Bariummagnesiumaluminat der Formel (I) entspricht:

$$a(Ba_{1-d}M^1_dO).b(Mg_{1-e}M^2_eO).c(Al_2O_3),$$

wobei:

$M^1$ für ein Seltenerdmetall steht, bei dem es sich spezieller um Gadolinium, Terbium, Yttrium, Ytterbium, Europium, Neodym und Dysprosium handeln kann;
$M^2$ für Zink, Mangan oder Cobalt steht;
a, b, c, d und e die folgenden Bedingungen erfüllen:
$0,25 \leq a \leq 2$; $0 < b \leq 2$; $3 \leq c \leq 9$; $0 \leq d \leq 0,4$ und $0 \leq e \leq 0,6$.

12. Verfahren nach Anspruch 11, **dadurch gekennzeichnet, dass** das Bariummagnesiumaluminat der obigen Formel (I) entspricht, wobei a = b = 1 und c = 5 oder a = b = 1 und c = 7 oder auch a = 1, b = 2 und c = 8.

13. Vorrichtung vom Typ Plasmasystem, Quecksilberdampflampe oder Elektrolumineszenzdiode, **dadurch gekennzeichnet, dass** sie eine Aluminatsuspension nach einem der Ansprüche 1 bis 6 oder eine durch das Verfahren nach einem der Ansprüche 7 bis 12 erhaltene Aluminatsuspension umfasst oder unter Verwendung einer Aluminatsuspension nach einem der Ansprüche 1 bis 6 oder einer durch das Verfahren nach einem der Ansprüche 7 bis 12 erhaltenen Aluminatsuspension hergestellt wird.

14. Lumineszenzmaterial, **dadurch gekennzeichnet, dass** es eine Matrix von Polymertyp umfasst, in die Aluminatteilchen eingearbeitet sind, und die unter Verwendung einer Aluminatsuspension nach einem der Ansprüche 1 bis 6 oder einer durch das Verfahren nach einem der Ansprüche 7 bis 12 erhaltenen Aluminatsuspension hergestellt worden ist.

15. Lumineszenzmaterial, umfassend ein Substrat oder eine Schicht auf diesem Substrat, **dadurch gekennzeichnet, dass** es durch Abscheiden einer einer Aluminatsuspension nach einem der Ansprüche 1 bis 6 oder einer durch das Verfahren nach einem der Ansprüche 7 bis 12 erhaltenen Aluminatsuspension auf dem Substrat erhalten worden ist.

16. Material nach Anspruch 14, **dadurch gekennzeichnet, dass** es transparent ist und eine Trübung (Haze) von höchstens 60 % und eine Gesamttransmission von mindestens 60 % aufweist und dass das obige Aluminat eine mittlere Teilchengröße zwischen 100 nm und 200 nm aufweist.

17. Lumineszierendes System, **dadurch gekennzeichnet, dass** es ein Material nach Anspruch 14 oder 15 und außerdem eine Anregungsquelle umfasst.

**Claims**

1. Barium magnesium aluminate suspension, **characterized in that** it is provided in the form of substantially monocrystalline particles in a liquid phase, the particles exhibiting a mean size $d_{50}$ of between 100 and 150 nm and also a dispersion index $\sigma/m$ of at most 1, $\sigma/m$ being defined by the ratio:

$$\sigma/m = (d_{84}-d_{16})/2d_{50}$$

in which:

- $d_{84}$ is the diameter of the particles for which 84% of the particles have a diameter of less than $d_{84}$;
- $d_{16}$ is the diameter of the particles for which 16% of the particles have a diameter of less than $d_{16}$;
- $d_{50}$ is the mean diameter of the particles;

the mean size $d_{50}$ and the dispersion index being determined with the help of a laser particle sizer using a volume distribution.

2. Suspension according to Claim 1, **characterized in that** the particles are provided in a form such that the ratio of the mean size of the said particles, measured by the laser diffraction technique, to the mean size of the same particles, measured by X-ray diffraction, is less than 2, more particularly is at most 1.5.

3. Suspension according to either of the preceding claims, **characterized in that** the particles exhibit a dispersion index of at most 0.7.

4. Suspension according to one of the preceding claims, **characterized in that** the barium magnesium aluminate is crystallized in the form of a pure phase.

5. Suspension according to one of the preceding claims, **characterized in that** the barium magnesium aluminate corresponds to the formula (I):

$$a(Ba_{1-d}M^1_dO).b(Mg_{1-e}M^2_eO).c(Al_2O_3)$$

in which:

M$^1$ denotes a rare earth metal which may more particularly be gadolinium, terbium, yttrium, ytterbium, europium, neodymium and dysprosium;
M$^2$ denotes zinc, manganese or cobalt;
a, b, c, d and e adhere to the relationships:
$0.25 \leq a \leq 2$; $0 < b \leq 2$; $3 \leq c \leq 9$; $0 \leq d \leq 0.4$ and $0 \leq e \leq 0.6$.

6. Suspension according to Claim 5, **characterized in that** the barium magnesium aluminate corresponds to the abovementioned formula (I) in which a = b = 1 and c = 5; or a = b = 1 and c = 7 or else a = 1, b = 2 and c = 8.

7. Process for the preparation of a suspension of substantially monocrystalline barium magnesium aluminate particles in a liquid phase, the particles exhibiting a mean size $d_{50}$ of between 80 nm and 200 nm, the mean size $d_{50}$ being determined with the help of a laser particle sizer using a volume distribution,
**characterized in that** it comprises the following steps:

- a liquid mixture comprising compounds of aluminium and of the other elements participating in the composition of the aluminate is formed;
- the said mixture is dried by atomization, the mixture being sprayed into a hot atmosphere, the outlet temperature of the solid being between 100°C and 300°C;
- the dried product is calcined at a temperature of at least 1100°C, either under air or under a reducing atmosphere;

it being possible for this calcination step to be preceded by a preliminary calcination at a temperature below 1000°C;

- a wet grinding of the product resulting from the calcination is carried out.

8. Process according to Claim 7, **characterized in that** two calcinations are carried out, the first under air and the second under a reducing atmosphere.

9. Process according to Claim 7 or 8, **characterized in that** use is made, as aluminium compound, of a sol of this element.

10. Process according to either of Claim 7 and 8, **characterized in that** nitrates are used as compounds of aluminium and of the abovementioned elements.

11. Process according to one of Claims 7 to 10, **characterized in that** the barium magnesium aluminate corresponds to the formula (I):

$$a(Ba_{1-d}M^1_dO).b(Mg_{1-e}M^2_eO).c(Al_2O_3)$$

in which:

$M^1$ denotes a rare earth metal which may more particularly be gadolinium, terbium, yttrium, ytterbium, europium, neodymium and dysprosium;
$M^2$ denotes zinc, manganese or cobalt;
a, b, c, d and e adhere to the relationships:
$0.25 \leq a \leq 2; 0 < b \leq 2; 3 \leq c \leq 9; 0 \leq d \leq 0.4$ and $0 \leq e \leq 0.6$.

12. Process according to Claim 11, **characterized in that** the barium magnesium aluminate corresponds to the abovementioned formula (I) in which a = b = 1 and c = 5; or a = b = 1 and c = 7 or else a = 1, b = 2 and c = 8.

13. Device of the plasma system, mercury vapour lamp or light-emitting diode type, **characterized in that** it comprises, or **in that** it is manufactured using, an aluminate suspension according to one of Claims 1 to 6 or an aluminate suspension obtained by the process according to one of Claims 7 to 12.

14. Luminescent material, **characterized in that** it comprises a matrix of polymer type in which aluminate particles are incorporated and which has been manufactured using an aluminate suspension according to one of Claims 1 to 6 or an aluminate suspension obtained by the process according to one of Claims 7 to 12.

15. Luminescent material comprising a substrate and a layer on the substrate, **characterized in that** it has been obtained by deposition, on the substrate, of an aluminate suspension according to one of Claims 1 to 6 or an aluminate suspension obtained by the process according to one of Claims 7 to 12.

16. Material according to Claim 14, **characterized in that** it is transparent and exhibits a haze of at most 60% and a total transmission of at least 60% and **in that** the abovementioned aluminate exhibits a mean particle size of between 100 nm and 200 nm.

17. Luminescent system, **characterized in that** it comprises a material according to Claim 14 or 15 and, in addition, a source of excitation.

Figure 1

Figure 2

Figure 3

Figure 4

Figure 5

Longueur d'onde (nm)

Figure 6

Longueur d'onde (nm)

**EP 2 265 690 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2007246873 A
- US 20030203205 A
- FR 2257326
- FR 2419754
- FR 2431321
- FR 2431321 A1

**Littérature non-brevet citée dans la description**

- **WATANABE A. et al.** *ITE Letters on Batteries, New Technologies & Medicine,* 2007, vol. 8 (1), 38-41
- **PANATARANI, C. et al.** *Materials Science and Engineering B,* 2005, vol. 122, 188-195
- SPRAY-DRYING. 1976